Europäisches Patentamt

European Patent Office

Office européen des brevets

(19)

(11) **EP 0 604 567 B1**

(12) **EUROPEAN PATENT SPECIFICATION**

(45) Date of publication and mention
of the grant of the patent:
**09.06.1999 Bulletin 1999/23**

(21) Application number: **92920738.9**

(22) Date of filing: **21.09.1992**

(51) Int Cl.⁶: **H03M 13/00**

(86) International application number:
**PCT/NO92/00156**

(87) International publication number:
**WO 93/06662 (01.04.1993 Gazette 1993/09)**

(54) **METHOD FOR CODING AND DECODING A DIGITAL MESSAGE**

**VERFAHREN ZUR KODIERUNG UND DEKODIERUNG EINER DIGITALEN NACHRICHT**

**PROCEDE DE CODAGE ET DECODAGE D'UN MESSAGE NUMERIQUE**

(84) Designated Contracting States:
**AT BE CH DE DK ES FR GB GR IE IT LI NL SE**

(30) Priority: **20.09.1991 NO 913705**

(43) Date of publication of application:
**06.07.1994 Bulletin 1994/27**

(73) Proprietors:
• **ABB SIGNAL AB**
**S-126 12 Stockholm (SE)**
• **ABB TEKNOLOGI AS**
**N-1361 Billingstadsletta (NO)**

(72) Inventors:
• **ENDRESEN, Jan**
**N-1362 Billingstad (NO)**
• **CARLSON, Erik**
**N-1456 Nesoddhogda (NO)**

(74) Representative: **Boecker, Joachim, Dr.-Ing.**
**Adelonstrasse 58**
**65929 Frankfurt am Main (DE)**

(56) References cited:
**WO-A-85/00714**          **US-A- 4 777 635**

• **CHAMBERS. Basics of Communications and
Coding, New York 1985; p. 122-150,
"Error-correcting codes"; see the whole
document.**

## Description

### Field of the invention

The present invention relates to a method for coding and transmitting a digital message comprising a first number of information bits and second a number of control bits, said message or code word being normally transmitted continuously.

Further, the invention relates to a method for receiving and decoding a transmitted digital message comprising a first number of information bits and a second number of control bits, said message or code word being received normally continuously.

### Background of the invention

The present invention has been developed in connection with automatic train control systems, but should not be limited to such systems. Further, the present invention has been developed in connection with intermittent communication, in which the communication can last only for a certain period of time due to physical constraints, but neither shall the invention be limited to this specific type of communication.

However, in the present specification the invention will be explained in connection with for example an automatic train system.

### Prior art

In intermittent communication which due to physical constraints can only last for a certain period, it is important to maximize the information transferred for a given reliability. An example is a train passing a radio beacon which transmits a message containing control information. The normal way to solve this problem is for the beacon to transmit a known synchronization bit pattern before the message. This may put a constraint on the information in the message to avoid false synchronization. To ensure that the train receives at least one complete message, it is necessary to allow time for almost two messages to be received since the receiver could just miss the first bit of a message and therefore have to wait for the next message.

Another way of solving the synchronization problem is to slave the radio beacon to the train receiver, but this is more complex and requires a transmitter in the train. The message is repeatedly transmitted by the beacon to increase the probability of correct reception. Those aspects of the system that are relevant can be summarized as follows.

* The beacon transmits a binary message of the given length n. This message is repeated without gaps for as long as the beacon gets enough power.

* The receiver must be able to determine the block boundaries in the received data stream.

* The probability of undetected error (the reliability) of the transmission must be guaranteed.

### Objects of the present invention

An object of the present invention is to provide a method, in which there is avoided the need to wait for a start of a block or message, and in which there is allowed data verification before synchronization.

Another object of the present invention is to provide a method, in which the received telegram can be as short as the length of the message or code word.

Yet another object of the present invention is to provide a method, in which the receiving time can be reduced to a minimum.

Still another object of the present invention is to provide a method, in which the probability of receiving a correct message and the correct synchronization thereof is guaranteed.

Further, an object of the present invention is to use error control codes in a new way giving a new code format in which error control and synchronization are combined in the same parity bits.

### Disclosure of the invention

In connection with a method as stated in the introductory part, the above objects are achieved in that on the transmitter side there is selected a generator polynomial producing a cyclic code, that said information bits are divided by said generator polynomial for thereby generating a remainder polynomial which is included in the message to be transmitted as said second number of control bits.

Thereby is achieved a valid code word provided the correct number of bits are received, but independent of the synchronization shift or start bit thereof.

In order to facilitate the control of any synchronization shift in the message or code word it is required that on the transmitter side there are selected first and second polynomials both being generators for cyclic codes, which polynomials are multiplied with each other, and that said information bits are divided by said products for thereby generating a remainder polynomial which is included in the message to be transmitted as said second number of control bits, and more specifically in that the first of the two cyclic code generator polynomials is used for controlling error detecting capability of the message in question, whereas the second of the two cyclic code generator polynomials is used for acquiring synchronization.

In a specific embodiment the length of the digital message or code word comprises a specific number of n bits, and there is used first and second selected generator polynomials which both produce cyclic code words of length n, said second generator polynomial being irreducible and not a factor in said first generator polynomial.

In a still more specific embodiment an offset polynomial is added modulo 2 to the remainder of the code word in question, the offset polynomial being divisable by the error control generator polynomial but not the synchronization generator polynomials.

Consequently, at the receiver side the method according to the present invention is characterized in that the message or code word is registered as such independently of the sequential appearance of the start of the information bits as long as the correct number of bits (n) in one message block are received.

Further features and advantages relating to the present invention will appear from the following detailed description, reference being made to the appending drawings.

Brief disclosue of the drawings

Fig. 1 illustrates the format of a code word block.

Fig. 2 illustrates the polynomial corresponding to the data seen through a window of length n.

Detailed description of embodiments

The present invention will now be explained in general terms, it being understood that the invention suggests using error control codes in a new way, for thereby generating a new code format in which error control and synchronization are combined in the same parity bits.

The code format

Binary vectors will be denoted by polynomials, e.g. the vector $v = [v_{k-1},...,v_1,v_o]$, is represented by the polynomial $v(x) = v_{k-1}x^{k-1}..+v_1x+v_o$. For references on coding theory see ref.1, 2 and 3.

The transmitted message (the code word) will be denoted by $c = [c_{n-1}...c_1,c_o]$, corresponding to the polynomial $c(x)$. The order of transmission is from left to right, i.e. $c_{n-1}$ is the bit transmitted first, then $c_{n-2}$, etc, and $c_o$ is transmitted last. The same message is repeated continually.

The transmitted messages are code words in a cyclic code of length n, the generator polynomial of which will be called $g(x)$; i.e. $c(x)$ is divisible by $g(x)$. A cyclic code is such that every valid code word can be divided into two parts and the parts interchanged, and the new code word will still be valid. The error detecting and error correcting capability of the proposed scheme comes from $g(x)$. The degree of $g(x)$ will be denoted by m.

A second polynomial, which will be denoted by $f(x)$, will be used for synchronization. The polynomial $f(x)$

* is irreducible
* divides $x^n-1$ but does not divide $x^m-1$ for $O<m<n$,
* is not a factor of $g(x)$.

These constraints are easily satisfied and still leave some freedom in the choice of $f(x)$. The degree of $f(x)$ will be denoted by l. The above constraints ensure that any cyclic shift of the code word has a unique syndrome with respect to $f(x)$.

For any two polynomials $h(x)$ and $p(x)$ non zero, let $R_{p(x)}[h(x)]$ denote the unique polynomial $r(x)$ of degree less than $deg[p(x)]$ that satisfies $h(x) = q(x)p(x) + r(x)$, i.e, it is the remainder that results from dividing $h(x)$ by $p(x)$.

Let $a(x)$ be the information polynomial, i.e, the polynomial corresponding to the binary vector $[a_{k-1},...a_1,a_0]$ of information bits. The number k of information bits equals n-l-m. Note that there is no constraint on the information bits, i.e, all $2^k$ possibilities are allowed.

The encoding rule is:

$$c(x) = x^{m+1} a(x)+R_{f(x)g(x)} [x^{m+1}a(x)]+o(x).$$

The multiplication of $a(x)$ with the factor $x^{m+1}$ has the effect of shifting the information m+l to the left, leaving m+l bits free for the parity and offset bits.

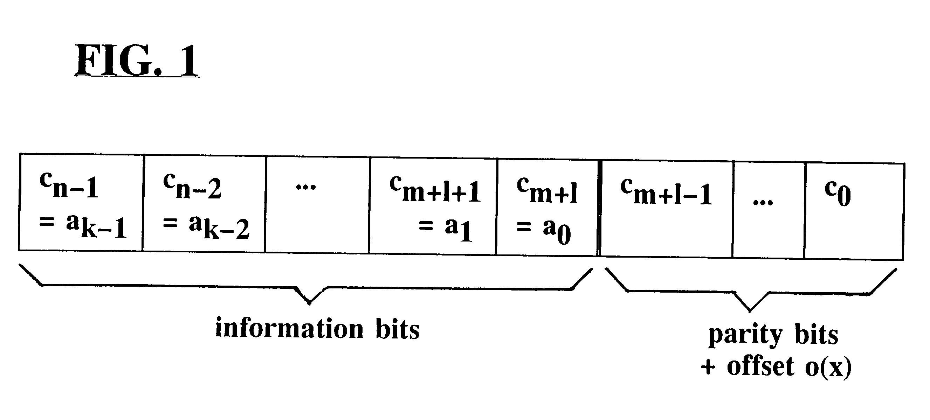

The remainder is calculated with respect to the product of $f(x)$ and $g(x)$. The binary polynomial $o(x)$ ("offset") is used for synchronization. It is divisable by $g(x)$ but not $f(x)$, and its degree is smaller that m + l. Any binary polynomial satisfying these constraints can be used; and as for $f(x)$ above, there is no reason to choose a particular $o(x)$. The resulting code format is shown in Fig.1.

The bits are transmitted from left to right, i.e, in the order $c_{n-1}$, $c_{n-2}$...,$c_1$, $c_0$, $c_{n-1}$, $c_{n-2}$...

Since $o(x)$ is divisible by $g(x)$, $c(x)$ is always divisible by $g(x)$ and is therefore a code word in the cyclic code generated by $g(x)$. Note also that $c(x)-o(x)$ is divisible by $f(x)$, but $c(x)$ is not.

The central idea of this code format is that in the absence of errors, any block of length n that is cut out of the transmitted data stream is a code word in the cyclic code generated by $g(x)$. Any such block is thus protected by the full error-detecting capability provided by $g(x)$. The code format of this section may be used with a varity of codes.

Decoding

The basic operation to be performed by the receiver is thus as follows:

1. Receive a block of n bits.

2. Look at a given window of length n. Verify this code word with respect to $g(x)$. If this is possible, go to step 3; otherwise shift the window and do step 2 again.

3. Recover data from window based on parity check with respect to f(x).

As an alternative, the shifting of the windows in the case of an unsuccessful decoding attempt can be left out. Permitting this shifting of the window increases the probability of successful transmission but also the probability of undetected error.

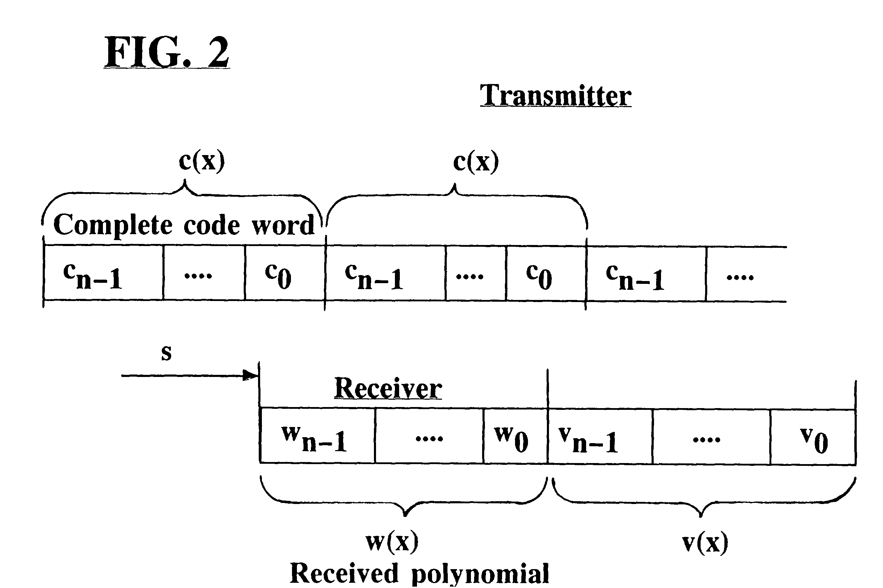

Now, consider point 3 of this procedure, i.e. the recovery of the information from the window. Let $w(x)$ be the polynomial that corresponds to the data block as seen through a window of length n that is shifted by s positions with respect to the block boundaries of the transmitted data, see Fig.2.

If s is the shift between the block boundaries of the data stream and the window, then $w(x)=R_xn_{-1}[x^s \cdot c(x)]$, provided that no error has occurred.

The result of the computation

$$R_{f(x)}[w(x)] = R_{f(x)}[R_x n_{-1}[x^s c(x)]]$$

$$= R_{f(x)}[x^s c(x)]$$

$$= R_{f(x)}[x^s R_{f(x)}[c(x)]]$$

$$= R_{f(x)}[x^s o(x)]$$

shows that all shift s in the range 0.....n-1 have unique syndrome $R_{f(x)}[w(x)]$. For, let s and s', $s \leq s'$ be two shifts in that range, and consider $R_{f(x)}[x^s o(x)] - R_{f(x)}[x^{s'} o(x)] = R_{f(x)}[x^s(1-x^{s'-s})o(x)]$. Since both $x_s$ and $o(x)$ have no common factors with f(x), this expression is zero if and only if f(x) divides $1-x^{s'-s}$; but since n is the smallest interger such that f(x) divides $x^n-1$, this implies s' = s. The information a(x) can thus easily be recovered from w(x): i.e. shifting w(x) cyclically s times to the right yields c(x).

References

1. W.W.Peterson and E.J.Weldon, Jr. Error-Correcting Codes, 2nd edition, Cambridge : MIT Press, 1972.

2. R.E.Blahut, Theory and Practice of Error Control Codes, Addison-Wesley, 1983.

3. Shu Lin and D.J. Costello, Error Control Coding, Fundamentals and Applications, Prentice Hall, 1983.

**Claims**

1. Method for coding and transmitting a digital message (c(x)) comprising a first number of information bits (a(x)) and second a number of control bits (b(x)), whereby on the transmitter side there is selected a generator polynomial (CRC(x)) producing a cyclic code, and said information bits (a(x)) are divided by said generator polynomial (CRC(x)) thereby generating a remainder polynomial $(c_r(x))$ which is included in the message to be transmitted as said second number of control bits $(a(x), c_r(x))$, **characterized** in that on the transmitter side first and second polynomials (g(x) and f(x)) are selected both being generators for cyclic codes, which polynomials are multiplied with each other, and that said information bits (a(x)) are divided by said product (g(x)*f(x)) for thereby generating said remainder polynomial $(c_r(x))$ which is included in the message to be transmitted as said second number of control bits $(a(x), c_r(x))$.

2. Method as claimed in claim 1, **characterized** in that a first of the two cyclic code generator polynomials (g(x)) is used for monitoring error detecting capability of the message in question, whereas a second of the two cyclic code generator polynomials (f(x)) is used for acquiring synchronisation.

3. Method as claimed in claim 1 or 2, **characterized** in that the length of the digital message or code word (c(x)) comprises a specific number of n bits (for example 255), and that there are used first and second selected generator polynomials (g(x) and f(x)) which both produce cyclic code words of length n, and that one generator polynomial (f(x)) is irreducible and not a factor in the other generator polynomial (g(x)).

4. Method as claimed in claim 2 or 3, **characterized** in that an offset polynomial (o(x)) is added modulo 2 to the remainder of the code word in question, and that the offset polynomial (o(x)) is divisible by the error control generator polynomial (g(x)) but not the synchronisation generator polynomial (f(x)).

5. Method for receiving and decoding a digital message (c(x)) according to claim 1 which message has been coded and transmitted according to any of claims 1 to 4, whereby at the receiver side the message or code word is registered as such independently of the sequential appearance of the start of information bits (a(x)) as long as the correct number of bits (n) in one message block are received, **characterized** in that at the receiver side the digital message or code word (c(x)) is divided by the same synchronisation generator polynomial (f(x)) as selected on the transmitter side, whereby a local remainder is obtained, which if non-zero determines uniquely the number of bits the code word has to be rotated to recover the information polynomial (a(x)).

6. Method as claimed in claim 5, **characterized** in that at the receiver side the digital message or code word (c(x)) is divided by the same error control generator polynomial (g(x)) as selected on the transmitter side, whereby there is obtained a local remainder, which if zero indicates a probable error free message or code word.

7. Method as claimed in claim 6, **characterized** in that at the receiver side the digital message or code word (c(x)) is rotated and divided by the same synchronisation generator polynomial (f(x)) as selected on the transmitter side, until the local remainder is equal to the remainder obtained by dividing the offset polynomial (o(x)) by the synchronisation generator polynomial (f(x)), and the information polynomial (a(x)) can be recovered from the first part of the rotated received code word (c(x)).

**Patentansprüche**

1. Verfahren zur Kodierung und Übertragung einer digitalen Nachricht (c(x)), die eine erste Anzahl von Informationsbits (a(x)) und eine zweite Anzahl von Steuerbits (b(x)) enthält, wobei auf der Transmitterseite ein Generatorpolynom (CRC(x)) gewählt wird, welches einen zyklischen Kode erzeugt, und wobei die genannten Informationsbits (a(x)) durch das genannte Generatorpolynom (CRC(x)) dividiert werden, wobei ein Restpolynom ($c_r(x)$) erzeugt wird, welches in der zu übertragenden Nachricht als die genannte zweite Anzahl von Steuerbits (a(x), $c_r(x)$) enthalten ist, **dadurch gekennzeichnet**, daß auf der Transmitterseite ein erstes und ein zweites Polynom (g(x) und f(x)) gewählt werden, die beide Generatoren für zyklische Kodes sind, welche Polynome miteinander multipliziert werden, und daß die genannten Informationsbits (a(x)) dividiert werden durch das genannte Produkt (g(x)·f(x)), um dadurch das genannte Restpolynom ($c_r(x)$) zu erzeugen, welches in der zu übertragenden Nachricht als die genannte zweite Anzahl von Steuerbits (a(x), $c_r(x)$) enthalten ist.

2. Verfahren nach Anspruch 1, **dadurch gekennzeichnet**, daß ein erstes der beiden zyklische Kode erzeugenden Generatorpolynome (g(x)) zur Überwachung der Fehlererkennungsfähigkeit für die betreffenden Nachricht verwendet wird, während ein zweiter der beiden zyklische Kode erzeugenden Generatorpolynome (f(x)) zur Erzielung der Synchronisation verwendet wird.

3. Verfahren nach Anspruch 1 oder 2, **dadurch gekennzeichnet**, daß die Länge der digitalen Nachricht oder des Kodewortes (c(x)) eine bestimmte Anzahl von n bits enthält (zum Beispiel 255) und daß ein erstes und ein zweites gewähltes Generatorpolynom (g(x) und f(x)), die beide zyklische Kodewöter der Länge n erzeugen, verwendet werden und daß ein Generatorpolynom (f(x)) unzerlegbar ist und kein Faktor in dem anderen Generatorpolynom (g(x)) ist.

4. Verfahren nach Anspruch 2 oder 3, **dadurch gekennzeichnet**, daß ein Offset-Polynom (o(x)) zu dem Rest des betreffenden Kodewortes Modulo-2 addiert wird und daß das Offset-Polynom (o(x)) durch das Fehlersteuer-Generatorpolynom (g(x)) teilbar ist, nicht jedoch das Synchronisations-Generatorpolynom (f(x)).

5. Verfahren zum Empfang und zur Dekodierung einer digitalen Nachricht (c(x)) gemäß Anspruch 1, welche Nachricht kodiert und übertragen wurde gemäß einem der Ansprüche 1 bis 4, wobei auf der Empfängerseite die Nachricht oder das Kodewort als solches registriert wird, unabhängig von der sequentiellen Erscheinung des Starts der Informationsbits (a(x)) solange die korrekte Anzahl von bits (n) in einem Nachrichtenblock empfangen wird, **dadurch gekennzeichnet**, daß auf der Empfängerseite die digitale Nachricht oder das Kodewort (c(x)) durch das gleiche Synchronisations-Generatorpolynom (f(x)) geteilt wird, welches auf der Transmitterseite gewählt wurde, wobei sich ein lokaler Rest ergibt, der, wenn er ungleich von Null ist, eindeutig die Anzahl von bits bestimmt, die das Kodewort rotiert werden muß, um das Informationspolynom (a(x)) wiederherzustellen.

6. Verfahren nach Anspruch 5, **dadurch gekennzeichnet**, daß auf der Empfängerseite die digitale Nachricht oder das Kodewort (c(x)) durch das gleiche Fehlersteuer-Generatorpolynom (g(x)) geteilt wird, welches auf der Transmitterseite gewählt wurde, wobei sich ein lokaler Rest ergibt, der, wenn er ungleich von Null ist, eine wahrscheinlich fehlerfreie Nachricht oder fehlerfreies Kodewort anzeigt.

7. Verfahren nach Anspruch 6, **dadurch gekennzeichnet**, daß auf der Empfängerseite die digitale Nachricht oder das Kodewort (c(x)) rotiert wird und geteilt wird durch das gleiche Synchronisations-Generatorpolynom (f(x)), welches auf der Transmitterseite gewählt wurde, bis der lokale Rest gleich dem Rest ist, der durch Dividieren des Offset-Polynoms (o(x)) durch das Synchronisations-Generatorpolynom (f(x)) erhalten wurde, und daß das Informationspolynom (a(x)) aus dem ersten Teil des rotierten empfangenen Kodeworts (c(x)) wiedergewonnen werden kann.

## Revendications

1. Procédé de codage et de transmission d'un message numérique (c(x)) comprenant un premier nombre de bits d'informations (a(x)) et un second nombre de bits de commande (b(x)), de sorte que du côté de l'émetteur soit sélectionné un polynôme générateur (CRC(x)) produisant un code cyclique, et lesdits bits d'informations (a(x)) sont divisés par ledit polynôme générateur (CRC(x)), générant ainsi un polynôme de reste ($c_r$(x)) qui est inclus dans le message à transmettre comme dit second nombre de bits de commande (a(x), $c_r$(x)), caractérisé en ce que, du côté de l'émetteur, un premier et un second polynômes (g(x) et f(x)) sont sélectionnés, tous deux étant des générateurs de codes cycliques, ces polynômes sont multipliés l'un par l'autre et lesdits bits d'information (a(x)) sont divisés par ledit produit (g(x)*f(x)) pour générer ainsi ledit polynôme de reste ($c_r$(x)) qui est inclus dans le message à transmettre comme dit second nombre de bits de commande (a(x), $c_r$(x)).

2. Procédé selon la revendication 1, caractérisé en ce qu'un premier des deux polynômes générateurs de codes cycliques (g(x)) est utilisé pour surveiller la possibilité de détection d'erreur du message en question, tandis qu'un second des deux polynômes générateurs de code cyclique (f(x)) est utilisé pour l'acquisition de la synchronisation.

3. Procédé selon la revendication 1 ou 2, caractérisé en ce que la longueur du message numérique ou mot de code (c(x)) comprend un nombre spécifique de n bits (par exemple, 255) et en ce que sont utilisés un premier et un second polynômes générateurs sélectionnés (g(x) et f(x)) qui produisent tous deux des mots de codes cycliques de longueur n et en ce qu'un polynôme générateur (f(x)) est irréductible et ne peut pas être mis en facteur dans l'autre polynôme générateur (g(x)).

4. Procédé selon la revendication 2 ou 3, caractérisé en ce qu'un polynôme de décalage (o(x)) est additionné modulo 2 au reste du mot de code en question et en ce que le polynôme de décalage (o(x)) est divisible par le polynôme générateur de commande d'erreur (g(x)), mais pas par le polynôme générateur de synchronisation (f(x)).

5. Procédé de réception et de décodage d'un message numérique (c(x)) selon la revendication 1, lequel message a été codé et transmis selon l'une quelconque des revendications 1 à 4, de façon que du côté du récepteur, le message ou mot de code soit positionné en tant que tel, indépendamment de l'aspect séquentiel du début des bits d'informations (a(x)) du moment que le nombre correct de bits (n) dans un bloc de message sont reçus, caractérisé en ce que, du côté du récepteur, le message numérique ou mot de code (c(x)) est divisé par le même polynôme générateur ce synchronisation (f(x)) que celui qui est sélectionné du côté de l'émetteur, de façon qu'un reste local soit obtenu, qui, s'il n'est pas nul, détermine de façon unique le nombre de bits dont le mot de code doit faire l'objet d'une rotation pour retrouver le polynôme d'informations (a(x)).

6. Procédé selon la revendication 5, caractérisé en ce que du côté du récepteur, le message numérique ou mot de code (c(x)) est divisé par le même polynôme générateur de commande d'erreur (g(x)) que celui qui est sélectionné du côté de l'émetteur, de façon que soit obtenu un reste local, qui, s'il est ni, indique un message ou mot de code probablement exempt d'erreur.

7. Procédé selon la revendication 6, caractérisé en ce que du côté du récepteur, le message numérique ou mot de code (c(x)) fait l'objet d'une rotation et est divisé par le même polynôme générateur de synchronisation (f(x)) que celui qui est sélectionné du côté de l'émetteur, jusqu'à ce que le reste local soit égal au reste obtenu en divisant le polynôme de décalage (o(x)) par le polynôme générateur de synchronisation (f(x)) et le polynôme d'information (a(x)) peut être récupéré à partir de la première partie du mot de code reçu (c(x)) ayant fait l'objet d'une rotation.

# FIG. 1

| $c_{n-1}$ $= a_{k-1}$ | $c_{n-2}$ $= a_{k-2}$ | ... | $c_{m+l+1}$ $= a_1$ | $c_{m+l}$ $= a_0$ | $c_{m+l-1}$ | ... | $c_0$ |
|---|---|---|---|---|---|---|---|

information bits

parity bits
+ offset o(x)

# FIG. 2

**Transmitter**

$c(x)$      $c(x)$

Complete code word

| $c_{n-1}$ | .... | $c_0$ | $c_{n-1}$ | .... | $c_0$ | $c_{n-1}$ | .... |
|-----------|------|-------|-----------|------|-------|-----------|------|

s

**Receiver**

| $w_{n-1}$ | .... | $w_0$ | $v_{n-1}$ | .... | $v_0$ |
|-----------|------|-------|-----------|------|-------|

$w(x)$      $v(x)$

**Received polynomial**